# EUROPÄISCHE PATENTSCHRIFT

(11) **EP 1 115 003 B1**
(45) Veröffentlichungstag und Bekanntmachung des Hinweises auf die Patenterteilung: **22.09.2004**
(21) Anmeldenummer: 00125068.7
(22) Anmeldetag: 17.11.2000
(51) Int. Cl.: G01R 31/36

(54) **Verfahren zur Erkennung einer defekten Kraftfahrzeug-Batterie**
Method of recognising a defective car battery
Procédé de reconnaissance d'une batterie de voiture défectueuse

(30) Priorität: 30.12.1999 DE 19964057
(43) Veröffentlichungstag der Anmeldung: 11.07.2001
(73) Patentinhaber: ROBERT BOSCH GMBH, 70442 Stuttgart (DE)
(72) Erfinder: Hiller, Burkhard, 71739 Oberriexingen (DE)

(56) Entgegenhaltungen:
- WO-A-98/48290
- US-A- 4 025 916
- US-A- 4 433 295

## Beschreibung

### Stand der Technik

Die Erfindung geht aus von einem Verfahren zur Erkennung einer defekten Batterie eines Kraftfahrzeugs, die während der Fahrt von einem Generator auf einen, von einem Steuergerät vorgegebenen Spannungssollwert aufgeladen und von einer elektrischen Last entladen wird, nach der Gattung des Hauptanspruchs. In der DE 33 133 98 C2 wird bereits eine Vorrichtung vorgeschlagen, bei der ein von dem Kraftfahrzeugmotor angetriebener Generator mittels eines Gleichrichters und eines Spannungsreglers eine Gleichspannung bzw. einen Gleichstrom zum Aufladen der Batterie liefert. Ein Mikrocomputer erfaßt dabei Signale, mit denen die Ladebedingungen für das Ladesystem berechnet werden. Die Batterie kann dadurch auf einen vorgegebenen Spannungs-Sollwert aufgeladen werden. Ein wesentliches Problem ist jedoch, daß man einer aufgeladenen Batterie nicht ohne weiteres ansehen kann, in welchem Ladezustand sie sich befindet und insbesondere wie groß die geladene und nutzbare Kapazität der Batterie ist, da die Kapazität einer Batterie nicht direkt meßbar ist. Es kann daher passieren, daß zwar die Batterie die vorgegebene Sollspannung aufweist, daß aber die Batterie beispielsweise aufgrund von Altersschwäche beispielsweise die erforderlichen hohen Ströme zum Starten des Verbrennungsmotors nicht mehr aufbringen kann. Der Verbrennungsmotor kann dann durch den Anlasser nicht mehr gestartet werden.

Aus der US-PS 4,025,916 sind Vorrichtungen bzw. Verfahren zur Anzeige eines Batterieladezustandes bekannt, bei denen bestimmte Parameter der Batterie ermittelt und die erhaltenen Ergebnisse ausgewertet werden. Als Parameter werden dabei Spannungen, insbesondere die Klemmenspannung der Batterie zu bestimmten Zeiten herangezogen. Durch Vergleich der Auswerteergebnisse mit vorgebbaren Werten kann eine Auswerteeinrichtung den aktuellen Batterieladezustand ermitteln und anzeigen.

Aus der DE 42 22 072 C2 ist eine Einrichtung zur Spannungsregelung bei einem, eine Batterie ladenden Generator bekannt, bei der der durch die Erregerwicklung fließende Erregerstrom abhängig von der an der Generatorklemme DF anstehenden Spannung begrenzt wird.

### Vorteile der Erfindung

Das erfindungsgemäße Verfahren zur Erkennung einer defekten Kraftfahrzeug-Batterie mit den kennzeichnenden Merkmalen des Hauptanspruchs hat demgegenüber den Vorteil, daß eine defekte oder altersschwache Batterie rechtzeitig erkannt wird und somit ein überraschendes Liegenbleiben des Kraftfahrzeugs vermieden werden kann. Insbesondere ist vorteilhaft, daß durch Bestimmung des Spannungsgradienten beim Auf- oder Entladen der Batterie auch Zwischenzustände für den aktuellen Batteriezustand ermittelbar sind, sodaß ähnlich wie bei einem abgefahrenen Reifenprofil ein Ausfall der Batterie nicht überraschend auftreten kann.

Durch die in den abhängigen Ansprüchen aufgeführten Maßnahmen sind vorteilhafte Weiterbildungen und Verbesserungen des im Hauptanspruch angegebenen Verfahrens möglich. Besonders vorteilhaft ist, daß das Steuergerät zur Bestimmung des Spannungsgradienten die Zeitspanne Zwischen zwei vorgegebenen Spannungswerten beim Auf- oder Entladen der Batterie mißt. Die Messung der Zeitspanne ist sehr einfach technisch durchführbar und erfordert keinen größeren Aufwand.

Günstig ist weiterhin, daß der Batteriezustand in einer Tabelle gespeichert wird, sodaß aufwendige Rechenmethoden vorteilhaft vermieden werden. Geeignete Methoden für die Bestimmung des Batteriezustandes sind sowohl die Messung des Spannungsgradienten, d.h. die Spannungsänderung innerhalb eines vorgegebenen Zeitintervalls als auch alternativ die Zeitspanne, in der sich die Batteriespannung um eine vorgegebene Differenz ändert.

Zur Erfassung der Last des Generators kann das DF-Signal als Tastverhältnis vom Erregerstrom gelesen werden. Das DF-Signal korrespondiert im wesentlichen mit dem Spannungsverlauf am Batterie-Pluspol. Eine zusätzliche Meßleitung zum Batterie-Pluspol ist dann nicht erforderlich.

Um Verfälschungen der Spannungskurve aufgrund von Lastschwankungen zu vermeiden, sollte beim Lade- bzw. Entladezyklus die elektrische Last des Bordnetzes möglichst konstant bleiben. Anderenfalls müßten Lastschwankungen durch entsprechende Kompensationsrechnungen herausgerechnet werden und damit der Spannungsgradient korrigiert werden.

Besonders vorteilhaft ist, daß der Batteriezustand durch die Speicherfähigkeit bestimmbar ist. Dadurch läßt sich feststellen, ob die Batterie noch genügend elektrische Energie speichern kann oder ob ihre Speicherfähigkeit erschöpft ist. Während des Betriebes ist es schwierig, dies festzustellen, da der Generator den elektrischen Energiebedarf abdeckt und so die Schwäche der Batterie überdecken kann. Auch beim Start fällt eine schwache Batterie unter günstigen Bedingungen nicht unbedingt auf. Beispielsweise bei kaltem Wetter kann sie aber dann plötzlich ihren Dienst versagen.

Die Speicherfähigkeit der Batterie ist durch einen einfachen Vergleich mit einer vorgegebenen Kennlinie ermittelbar. Das Ergebnis dieses Vergleiches kann vorteilhaft optisch oder akustisch auf einer entsprechenden Anzeige ausgegeben werden, sodaß der Fahrer des Kraftfahrzeugs jederzeit über den Batteriezustand informiert ist.

Da in modernen Kraftfahrzeugen die Vernetzung einzelner Aggregate zunimmt, ist die Verwendung einer Schnittstelle bzw. eines Reglers eine einfache Möglichkeit, die entsprechenden Signale vorteilhaft ohne zusätzliche Leitungen zu erfassen.

### Zeichnung

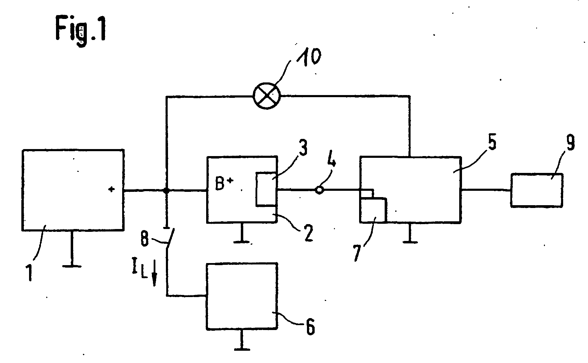

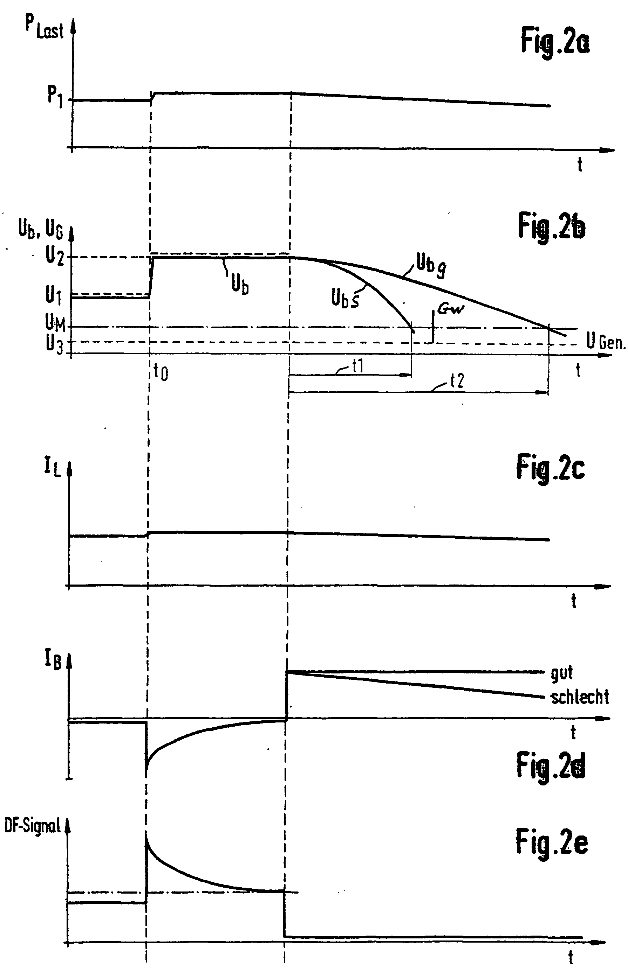

Ein Ausführungsbeispiel der Erfindung ist in den Figuren dargestellt und in der Beschreibung nachstehend erläutert. Es zeigen Figur 1 ein Blockschaltbild und die Figuren 2a - 2e zeigen Diagramme.

### Beschreibung

Das Blockschaltbild der Figur 1 zeigt in schematischer Darstellung eine Batterie 1, die über ihren Pluspol mit einem Generator 2 an einer Klemme B+ angeschlossen ist. An dieser Klemme B+ liegt die vom Generator erzeugte und gleichgerichtete Spannung an und über die der Ladestrom zum Pluspol der Batterie 1 fließt. Der Generator 2 ist üblicherweise ein Drehstromgenerator und hat einen Regler 3, mit dem die Ausgangsspannung an der Klemmme B+ geregelt wird. Der Regler 3 weist eine Schnittstelle 4 auf, an die ein Steuergerät 5 mit einem Spannungsmesser 7 angeschlossen ist. Sowohl die Generatorschaltung mit dem Regler als auch das Steuergerät 5 sind per se bekannt und müssen nicht näher erläutert werden. An einem Ausgang des Steuergerätes 5 ist eine Anzeige 9 angeschlossen, die als optische oder akustische Anzeige ausgebildet sein kann. Eine Kontrolleuchte 10, die ebenfalls per se bekannt ist, ist zwischen dem Steuergerät 5 und dem Pluspol der Batterie 1 geschaltet und leuchtet auf, wenn die Generatorspannung unterhalb der der Batterie 1 liegt.

An den Pluspol der Batterie 1 ist über einen Schalter 8 schematisch eine Last 6 geschaltet, die ein Verbraucher, beispielsweise die Zündanlage, die Heizung, Scheinwerfer usw. sein kann. Über schematisch dargestellte Minus-Anschlüsse wird der Stromkreis geschlossen.

Anhand der Diagramme der Figuren 2a - 2e wird die Funktionsweise der Erfindung näher erläutert. Die grundlegende Erfindungsidee wird darin gesehen, daß der augenblickliche Batteriezustand, im wesentlichen der Batterieladezustand oder Speicherfähigkeit am einfachsten durch den Spannungsverlauf beim Aufladen bzw. Entladen mit einer möglichst konstanten elektrischen Last erkannt werden kann. Dies kann im Fahrbetrieb oder beispielsweise mit laufendem Motor im Stand erfolgen. Um Verfälschungen zu vermeiden, sollten Lastschwankungen während des Lade- bzw. Entladezyklus möglichst vermieden werden. Anderenfalls müßten Lastschwankungen durch eine entsprechende Kompensationsrechnung herausgefiltert werden, um keine falschen Schlüsse für den Spannungsgradienten zu ziehen.

Anhand eines einfachen Beispiels soll nun erläutert werden, wie der Batteriezustand, insbesondere deren Speicherfähigkeit, bestimmt werden kann. Geht man beispielsweise von einer mittleren Generatorsollspannung von 13,8 V aus, dann wird zunächst das DF-Signal des Generators ausgelesen. Figur 2e zeigt den Spannungsverlauf an der Schnittstelle 4. Vorteilhaft ist dabei, die Generatorsollspannung nicht zu hoch zu wählen, da eine zu hohe Generatorsollspannung zwangsläufig auch dazu führt, daß die angeschlossenen Verbraucher stärker belastet werden. Andererseits soll die Batterie mit einem signifikanten Spannungshub, beispielsweise um 1 V auf 14,8 V geladen werden, um den Spannungsverlauf an der Generatorausgangsklemme B+, bzw. an dem Pluspol der Batterie 1 deutlich zu erkennen. Nehmen wir an, wir haben gemäß der Figur 2a eine Last mit der Leistung P1, die von dem Generator bzw. von der Batterie mit einer ersten Spannung U₁ geliefert wird (Figur 2b). Zum Zeitpunkt t₀ wird nun von dem Steuergerät 5 über die Schnittstelle 4 die Spannung für den Generator 2 auf die zweite Spannung U₂ erhöht. Wegen der höheren Spannung steigt auch die Leistung an unserer Last entsprechend an, wie der Figur 2a entnehmbar ist. Die Last 6 wird dabei mittels des Schalters 8 an den Pluspol der Batterie 1 geschaltet. Durch die höhere zweite Spannung U₂ wird nun die Batterie auf den Wert U₂, beispielsweise 14,8 V aufgeladen. Das Laden der Batterie 1 auf die höhere Spannung U₂ soll bewirken, daß sowohl ein guter Ladezustand der Batterie 1 erreicht als auch der Beobachtungszeitraum beim anschließenden Entladen verlängert wird, um so die Aussagegenauigkeit zu erhöhen. Figur 2c zeigt den entsprechenden Stromverlauf I_{L} an der Last 6. Der Batteriestrom I_{B} ist in Figur 2d dargestellt. Bis zum Zeitpunkt t₀ ist der Strom konstant. Der negative Strom bedeutet, daß ein kleiner Strom als Ladestrom in die Batterie fließt. Nach dem Anstieg der Spannung auf den Wert U₂ zum Zeitpunkt t₀ steigt der Ladestrom I_{B} zur Batterie stark an, er nähert sich mit der Zeit asymptotisch auf einen kleinen Reststrom. Beim Entladen der Batterie 1 ergibt sich gemäß Fig. 2d je nach Batteriezustand eine mehr oder weniger stark abfallende Stromkurve. Der obere Kurvenabschnitt g (gut) zeigt eine Batterie mit gutem und der untere Kurvenabschnitt s (schlecht) mit schlechtem Ladezustand. Dieser Vorgang läßt sich auch am DF-Signal gemäß der Figur 2e mitverfolgen.

Hat der Ladestrom I_{B} sich der 0-Achse (Zeitachse t, Fig. 2d) genähert, dann ist die Steigung der Kurve 0. Auch das DF-Signal ist nun deutlich unter 100%, d. h. die Batterie ist bei der vorgegebenen Spannung vollständig geladen. Der Generator 2 deckt außer dem Ladestrom für die Batterie auch den Energiebedarf des Bordnetzes ab. Wie hoch die Last ist, läßt sich am DF-Signal ablesen. In der Darstellung wurde jedoch auf eine Skalierung verzichtet, da das DF-Signal abhängig ist vom Generator- und Batterietyp.

Nachdem nun die Batterie 1 aufgeladen ist, wird nun die Generatorspannung sprungförmig beispielsweise auf den Wert 11,8 V heruntergesetzt, sodaß die Bordnetzversorgung mit der Last 6 ausschließlich von der Batterie 1 übernommen wird. In dieser Entladephase sollte die Last 6 konstant bleiben, um keine Verfälschung des Spannungsverlaufes (Spannungsgradient der Batteriespannung U_{b}) zu erhalten. In Figur 2b stellt die gestrichelte Linie die Generatorspannung U_{G} dar, während die durchgezogenen Linien die Batteriespannung U_{b} wiedergibt. Nachdem gemäß der Figur 2b die Generatorspannung sprungförmig auf den Wert U₃ abgesenkt wurde (im Beispiel auf 11,8 V), entlädt sich jetzt über die Zeit t₁ die Batterie mehr oder weniger schnell. Erreicht die Batteriespannung U_{b} eine Meßschwelle U_{M}, dann entspricht die Zeitspanne t₁ dem Wert für den Batteriezustand. Gemäß der Figur 2b soll die Kurve U_{bs} eine schlechte Batterie zeigen, während die Kurve U_{bg} einen guten Batteriezustand zeigt, weil sich die Batterie entsprechend dem größeren Zeitintervall t₂ langsamer entlädt. Aufgrund der gemessenen Zeitspannen t₁ bzw. t₂ in Bezug auf einen vorgegebenen Grenzwert Gw kann auf die Speicherfähigkeit der Batterie geschlossen werden. Entsprechend läßt sich bei einem festen Zeitintervall die Spannungsänderung auswerten.

Mit Hilfe der Kennlinien lassen sich nun über die Zeit entsprechend dem Verlauf des DF-Signals Grenzwerte festlegen, unterhalb derer auf eine defekte Batterie geschlossen werden kann. Sinkt nämlich die Spannung bei der vom Generator übermittelten Last schneller auf den vorgegebenen Wert, als er im Kennfeld angegeben ist, so ist die Speicherfähigkeit der Batterie ungenügend, und die Batterie wird als defekt auf der Anzeige 9 beispielsweise als skalierter Wert, Symbol oder in akustischer Form ausgegeben. Natürlich müssen die Werte für die Kennlinie entsprechend des Batterietyps zuvor beispielsweise empirisch ermittelt und der Messung zugrunde gelegt werden. Dabei ist auch zu beachten, daß die Bordnetzspannung höchstens auf die Generatorspannung absinken kann.

## Patentansprüche

1. Verfahren zur Erkennung des Zustandes einer Batterie (1), die bei laufendem Motor von einem Generator (2) auf einen von einem Steuergerät (5) vorgegebenen Spannungssollwert aufgeladen und von einer elektrischen Last (6) entladen wird, **dadurch gekennzeichnet, dass** ein Spannungsmesser (7) vorgesehen ist, der die Generator- oder die Batteriespannung kontinuierlich erfasst, dass die Sollspannung des Generators zunächst um einen definierten Wert erhöht wird und damit auch die Batteriespannung sich erhöht und anschließend mit einer Last (6) des Bordnetzes um einen zweiten vorgegebenen Spannungswert entladen wird, und dass das Steuergerät (5) aus dem Spannungsgradienten einen Wert für den aktuellen Batteriezustand ermittelt.

2. Verfahren nach Anspruch 1, **dadurch gekennzeichnet, dass** das Steuergerät (5) aus der Zeitspanne zwischen zwei vorgegebenen Spannungsschwellwerten beim Laden oder Entladen der Batterie (1) den Wert für den Batteriezustand ermittelt.

3. Verfahren nach Anspruch 1 oder 2, **dadurch gekennzeichnet, dass** der Batteriezustand in Abhängigkeit von den gemessenen Parametern in einer Tabelle gespeichert wird.

4. Verfahren nach einem der vorhergehenden Ansprüche, **dadurch gekennzeichnet, dass** der Batteriezustand in Abhängigkeit von dem Spannungsgradienten, der eine Spannungsänderung pro Zeiteinheit entspricht, gespeichert wird.

5. Verfahren nach einem der vorhergehenden Ansprüche, **dadurch gekennzeichnet, dass** das DF-Signal vom Generator (2) zur Bestimmung der Last (6) kontinuierlich erfasst wird.

6. Verfahren nach einem der vorhergehenden Ansprüche, **dadurch gekennzeichnet, dass** die Last (6) des Bordnetzes während der Entladephase konstant gehalten wird.

7. Verfahren nach einem der vorhergehenden Ansprüche, **dadurch gekennzeichnet, dass** als Batteriezustand die Speicherfähigkeit der Batterie (1) als Batterieladezustand gilt.

8. Verfahren nach Anspruch 7, **dadurch gekennzeichnet, dass** die Speicherfähigkeit der Batterie ausgehend von einer Kennlinie ermittelt wird, die den zeitlichen Verlauf einer Größe, Ub oder Ib oder DF-Signal darstellt und der Vergleich dieser Kennlinie mit einem vorgebbaren Wert erkennen lässt, dass die Speicherfähigkeit der Batterie ungenügend ist.

9. Verfahren nach einem der vorhergehenden Ansprüche, **dadurch gekennzeichnet, dass** bei einem schlechten Batteriezustand eine optische und/oder akustische Anzeige ausgelöst wird, wobei ein schlechter Batteriezustand erkannt wird, wenn vorgebbare Kriterien erreicht werden.

10. Verfahren nach einem der vorhergehenden Ansprüche, **dadurch gekennzeichnet, dass** der Generator (2) bzw. der Regler (3) eine Schnittstelle (4) aufweist, über die das Steuergerät (5) die Generatorsollspannung vorgibt und das DF-Signal ausliest.

## Claims

1. Method for identification of the state of a battery (1) which, when the engine is running, is charged by a generator (2) to a nominal voltage value predetermined by a controller (5) and is discharged by an electrical load (6), **characterized in that** a voltmeter (7) is provided, which continuously records the generator voltage or the battery voltage, **in that** the nominal voltage of the generator is first of all increased by a defined value so that the battery voltage is thus also increased, and is then discharged by a second predetermined voltage value by means of a load (6) on the vehicle power supply system, and **in that** the controller (5) uses the voltage gradient to determine a value for the instantaneous battery state.

2. Method according to Claim 1, **characterized in that** the controller (5) determines the value for the battery state from the time interval between two predetermined voltage threshold values during charging or discharging of the battery (1).

3. Method according to Claim 1 or 2, **characterized in that** the battery state is stored in a table, as a function of the measured parameters.

4. Method according to one of the preceding claims, **characterized in that** the battery state is stored as a function of the voltage gradient, which corresponds to a voltage change per unit time.

5. Method according to one of the preceding claims, **characterized in that** the DF signal from the generator (2) is recorded continuously in order to determine the load (6).

6. Method according to one of the preceding claims, **characterized in that** the load (6) on the vehicle power supply system is kept constant during the discharging phase.

7. Method according to one of the preceding claims, **characterized in that** the storage capacity of the battery (1) as the battery state of charge is used as the battery state.

8. Method according to Claim 7, **characterized in that** the storage capacity of the battery is determined on the basis of a characteristic which represents the time profile of a variable, Ub or Ib or DF signal, and the comparison of this characteristic with a value which can be predetermined makes it possible to identify that the storage capacity of the battery is inadequate.

9. Method according to one of the preceding claims, **characterized in that**, if the battery state is poor, a visual and/or audible indication is triggered, with a poor battery state being identified when criteria which can be predetermined are reached.

10. Method according to one of the preceding claims, **characterized in that** the generator (2) or the regulator (3) has an interface (4) via which the controller (5) presets the nominal generator voltage and reads the DF signal.

## Revendications

1. Procédé de détection de l'état d'une batterie (1) qui, lorsque le moteur tourne, est chargée par un générateur (2) sur une valeur de consigne de tension prédéterminée par un appareil de commande (5) et déchargée par une charge électrique (6),
**caractérisé en ce qu'**
un voltmètre (7) mesure continuellement la tension de générateur ou de batterie, la tension de consigne du générateur est d'abord augmentée d'une valeur définie, ce qui provoque l'augmentation également de la tension de batterie, puis déchargée d'une deuxième valeur de tension prédéterminée avec une charge (6) du réseau de bord, et l'appareil de commande (5) détermine à partir du gradient de tension une valeur pour l'état actuel de la batterie.

2. Procédé selon la revendication 1,
**caractérisé en ce que**
l'appareil de commande (5) détermine la valeur pour l'état de la batterie à partir d'un intervalle de temps entre deux valeurs seuils de tension prédéterminées lors du chargement ou du déchargement de la batterie (1).

3. Procédé selon la revendication 1 ou 2,
**caractérisé en ce que**
l'état de la batterie est mémorisé dans un tableau en fonction des paramètres mesurés.

4. Procédé selon l'une quelconque des revendications précédentes,
**caractérisé en ce que**
l'état de la batterie est mémorisé en fonction du gradient de tension auquel correspond une variation de tension par unité de temps.

5. Procédé selon l'une quelconque des revendications précédentes,
**caractérisé en ce que**
le signal DF du générateur (2) est continuellement relevé pour déterminer la charge (6).

6. Procédé selon l'une quelconque des revendications précédentes,
**caractérisé en ce que**
la charge (6) du réseau de bord est maintenue constante pendant la phase de déchargement.

7. Procédé selon l'une quelconque des revendications précédentes,
**caractérisé en ce que**
comme état de la batterie, la capacité d'accumulation de la batterie (1) représente l'état de charge de la batterie.

8. Procédé selon la revendication 7,
**caractérisé en ce que**
la capacité d'accumulation de la batterie est déterminée à partir d'une ligne caractéristique représentant la courbe dans le temps d'une grandeur, Ub ou Ib ou du signal DF, et la comparaison de cette ligne caractéristique à une valeur pouvant être prédéterminée permet de détecter que la capacité d'accumulation de la batterie est insuffisante.

9. Procédé selon l'une quelconque des revendications précédentes,
**caractérisé en ce qu'**
en cas d'un mauvais état de batterie une indication optique et/ou acoustique est déclenchée, un mauvais état de batterie étant détecté lorsque des critères pouvant être prédéterminés sont atteints.

10. Procédé selon l'une quelconque des revendications précédentes,
**caractérisé en ce que**
le générateur (2) ou le régulateur (3) présente une interface (4) par laquelle l'appareil de commande (5) prédétermine la tension de consigne de générateur et lit le signal DF.
